# EUROPEAN PATENT APPLICATION

(11) **EP 4 734 743 A1**
(43) Date of publication of application: **29.04.2026**
(21) Application number: 25211050.7
(22) Date of filing: 24.10.2025
(51) Int. Cl.: H10W 72/90, H10W 20/41, H10W 90/10

(54) **CHIPS-ON-RAILS SYSTEM IN PACKAGE**

(30) Priority: 28.10.2024 IN 202441082438
(71) Applicant: NXP USA, Inc., Austin, TX 78735 (US)
(72) Inventor: Reber, Douglas Michael, 5656AG Eindhoven (NL); Bhooshan, Rishi, 5656AG Eindhoven (NL)
(74) Representative: Colaiuda, Antonella

(57) **Abstract**

A multi-level interconnect structure is formed on a semiconductor wafer to include conductive power-distribution rail bonding structures which are positioned for mounting on a package substate by forming a patterned insulator layer on the multi-level interconnect structure which includes a defined array of patterned openings, and then forming an array of conductive power-distribution rail bonding structures in the defined array of patterned openings to extend substantially over the top surface of the interconnect structure, where the array of conductive power-distribution rail bonding structures includes a plurality of parallel conductive rails which are aligned in parallel and distributed uniformly to directly electrically connect power over the plurality of conductive interconnect structures to the IC device.

## Description

### BACKGROUND OF THE INVENTION

### Field of the Invention

The present disclosure is directed in general to the field of semiconductor devices. In one aspect, the present disclosure relates to an integrated circuit assembly for attaching integrated circuit dies or modules together on a multi-chip package substrate.

### Description of the Related Art

Modern integrated circuits (ICs) typically have conductor structures formed in a plurality of inter-layer dielectric (ILD) layers to provide conductive interconnect levels, which provide electrical connections to and from circuitry that is formed on the IC substrate. These conductors can be used to transfer information in the form of signals sent to and from ICs formed on an underlying substrate. In addition, conductor structures may be formed in the ILD layers to provide other circuit elements, such as capacitor plates that are electrically connected to the circuitry that is formed on the IC substrate. After forming the circuitry on the substrate during front-end-of-line (FEOL) processing, existing copper metallization techniques for semiconductor wafer-fabrication form inter-level conductor structures in a series of ILD layers by patterning and etching each ILD layer to form etch openings, plating, and/or filling each etch opening with one or more conductive layers, and then applying a chemical-mechanical planarization (CMP) or polish step to remove the conductive layer(s) from outside the etch openings.

With shrinking technology and increasing power consumption, interconnect resistance (IR) drop through the conductive interconnect levels is becoming a very significant problem for designs using wire-bond packaging. To reduce the voltage IR drop, the number of thick metal layers needs to be increased in the die interconnects and/or flip-chip packaging should be employed, but such solutions will increase die and packaging cost. Other solutions for reducing IR drop include forming copper pillar conductors at interior regions of the die which make direct electrical contact through the interconnect to the circuit elements on the die (instead of travelling "laterally" from die pads at the periphery of the die). However, copper pillar conductors introduce packaging stresses that are non-uniformly distributed on the die, creating design and tapeout issues. In particular, semiconductor chips can experience stress in the FEOL transistor layers when packaged with copper pillars or through-silicon vias. These stresses are typically not factored into the modelling and therefore the actual silicon performance will not be as expected. For copper pillars, the typical solution is to institute keep-out-zones around the pillars under which sensitive devices are prohibited. However, this is problematic because in order to achieve good pillar bonding, the pillars must be added in sufficient density in all areas which leave little remaining area for the sensitive device placement. In addition, stresses from coper pillars and wirebond pads can require underpad metallization density rules which restrict routing and can require very restrictive via stacking rules.

As seen from the foregoing, existing designs and fabrication processes for IC devices have not provided the cost, speed, and electrical performance required for leading-edge IC devices. In addition, existing IC devices suffer from potential product delays resulting from product redesign and tapeout delays if any of the density and placement constraints are not respected or if late changes to the rules are made by the wafer foundry. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 is a simplified cross-section view of an integrated circuit package assembly including a plurality of integrated circuit devices mounted on a multi-chip substrate in accordance with selected embodiments of the present disclosure.
Figures 2-12 illustrate a sequence of cross-sectional and plan views of a semiconductor chip with rail conductors formed over the interconnect layers in accordance with selected embodiments of the present disclosure.
Figures 13-14 illustrate cross-sectional and plan views of a semiconductor chip with rail conductors and recessed seal ring/crack-stop structures formed over the interconnect layers in accordance with selected embodiments of the present disclosure.
Figures 15-23 illustrate a sequence of cross-sectional views of a package substrate with rail conductor slots formed to receive rail conductors from a mounted semiconductor chip in accordance with selected embodiments of the present disclosure.
Figure 24 illustrates a plan view of a semiconductor chip with a plurality of rail conductor arrays disposed the interconnect layers in accordance with selected embodiments of the present disclosure.

### DETAILED DESCRIPTION

A process for fabricating ICs is described wherein highly conductive chip rail bonding structures are formed as an array of parallel conductive rails extending substantially over a top surface of the back-end-of-line (BEOL) interconnect layers of an IC device to provide package-to-chip electrical connections with minimal IR drop and negligible electromigration concern. In addition, a process for fabricating multi-chip package substrates is described wherein package substrates are provided with highly conductive substrate rail bonding structures or with rail conductor slots formed to receive the chip rail bonding structures. In selected embodiments of the present disclosure, the chip rail bonding structures are formed as an array of regularly-arranged and in-line (RAIL) interconnects which extend across a substantial portion of the top surface of the semiconductor chip, where a "substantial portion" refers to a RAIL interconnect length dimension that is at least 2-3 times the aligned width or length dimension of an underlying copper pillar. In other selected embodiments of the present disclosure, a "substantial portion" refers to a RAIL interconnect length dimension that extends across at least 10% of the top surface of the semiconductor wafer substrate which forms a single integrated circuit die or chip. In selected embodiments, an individual conductive rail which extends over the top surface of the BEOL interconnect layers as a traversing trace is positioned to make directly electrical contact with one or more vertical conductor layers (e.g., a copper pillar) which extends "down" through the BEOL interconnect layers of an IC device to provide a reference voltage or signal connection to an IC device formed in the semiconductor substrate. In other embodiments, different arrays of parallel conductive rails may be formed in different regions of the IC device so that the conductive rail structures in each region extend in a coherent direction throughout the region in order to obtain substantially uniform stress in that region. In selected embodiments, an array of parallel conductive rails having length dimensions which traverse across a region of the chip may have a width dimension that is much smaller than the dimensions of a typical bond, TSV, or pillar, and may also be formed or routed to avoid seal-ring areas at the periphery and/or inductors and other RF passive devices formed in the interior region of the chip. As will be appreciated, the rail width/pitch can be in the range of allowed min/max rules. In addition to minimizing stress effects and reducing IR drop, the conductive rail array can effectively function as an EMI shield and a radiative heat sink when the spacing between conductive rail elements is close enough.

In this disclosure, an improved IC structure and method of manufacture are described for forming an array of conductive rail bonding structures over a multi-level interconnect structure of one or more semiconductor chips so as to promote a low IR drop integrated circuit assembly for attaching the one or more semiconductor chips on a package substrate to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process-technology requirements or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross-sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

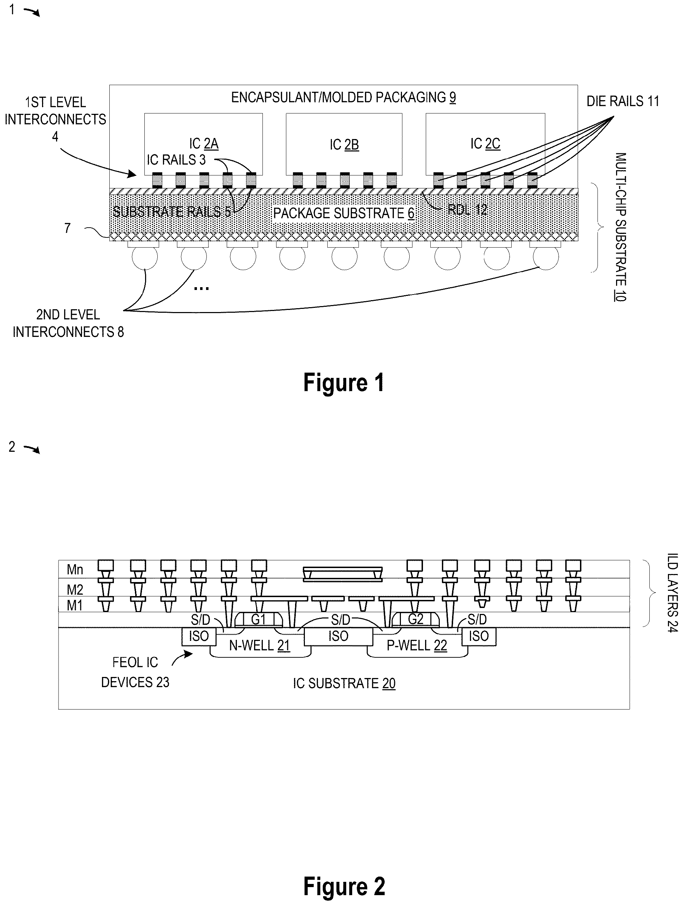

For an improved understanding of selected embodiments of the present disclosure, reference is now made to Figure 1 which depicts a simplified cross-section view of an integrated circuit package assembly 1 which includes a plurality of integrated circuit devices 2A-C which are affixed or mounted on a multi-chip substrate 10 and which are encapsulated in a molded packaging structures 9. Implemented as a flip chip package, the integrated circuit package assembly 1 includes first level interconnects 4 connecting the discrete chips 2A-C to the multi-chip substrate 10, and also includes second level interconnects 8 connecting the multi-chip substrate 10 to external circuits, such as a printed circuit board (not shown). As depicted, the electronic integrated circuits 2A-C are positioned and attached with face-down IC rails 3 for alignment with the embedded face-up substrate rails 5 in the package substrate 6. In addition, an array of conductive die rails 11 is aligned and positioned to make direct electrical connection between the IC rails 3 and substrate rails 5. Though not visible from the cross-sectional image in Figure 1, it will be appreciated that the array of conductive die rails 11 extends orthogonally to the plane shown in Figure 1 to substantially cover the bottom surfaces of the BEOL interconnect layers of the integrated circuit devices 2A-C. In addition or in the alternative, it will be appreciated that the array of conductive die rails 11 extends orthogonally to the plane shown in Figure 1 to substantially cover the top surface of the multi-chip substrate 10. On the package substrate 6, a first redistribution line (RDL) stack layer 12 may be formed with fine-pitch routing layers embedded in a stack of insulator layers (not shown) to connect the face-up substrate rails 5 through the package substrate 6 to a second RDL stack layer 7 which also includes fine-pitch routing layers embedded in a stack of insulator layers (not shown) for routing to the second level interconnects 8 (e.g., solder balls or bumps or grid arrays).

Various illustrative embodiments of the present invention will now be described in detail with reference to Figures 1-24. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

For an improved understanding of selected embodiments of the present disclosure, reference is now made to Figures 2-14 which illustrate a sequence of cross-sectional and plan views at different stages of manufacture of a semiconductor structure having rail conductors formed over the interconnect layers. In particular, Figure 2 illustrates a cross-sectional view a portion of a semiconductor structure 2 having one or more inter-layer dielectric (ILD) layers 24 formed over a semiconductor substrate 20 in which one or more IC devices or elements 23 are fabricated with FEOL wafer-processing steps. As will be appreciated, the FEOL IC devices or elements 23 may include one or more transistors, resistors, capacitors, diodes, or other semiconductor components that are formed on or in a semiconductor substrate with any suitable semiconductor material or combinations of materials, such as gallium arsenide, gallium nitride, silicon germanium, semiconductor-on-insulator (SOI), strained semiconductor-on-insulator (SSOI), silicon, monocrystalline silicon, and the like. As depicted, the transistors may include gates G1, G2 formed over source/drain (S/D) regions and channel regions formed in an n-well 21 or p-well 22. In addition, the transistors may be separated from one another by isolation regions (ISO). Over the IC elements, one or more insulating ILD layers 24 may be formed with any suitable insulating material to separate and define patterned conductive metal lines or layers M1, M2, Mn formed therein. Though not shown, it will be appreciated that one or more copper pillar conductors may be formed over the multi-level interconnect structure (e.g., in the final termination Aluminum layer and above) or conductive through-silicon via structures which in turn are connected to buried conductors formed in the ILD layers 24 to provide a low resistance conduction path to the one or more IC devices or elements 23.

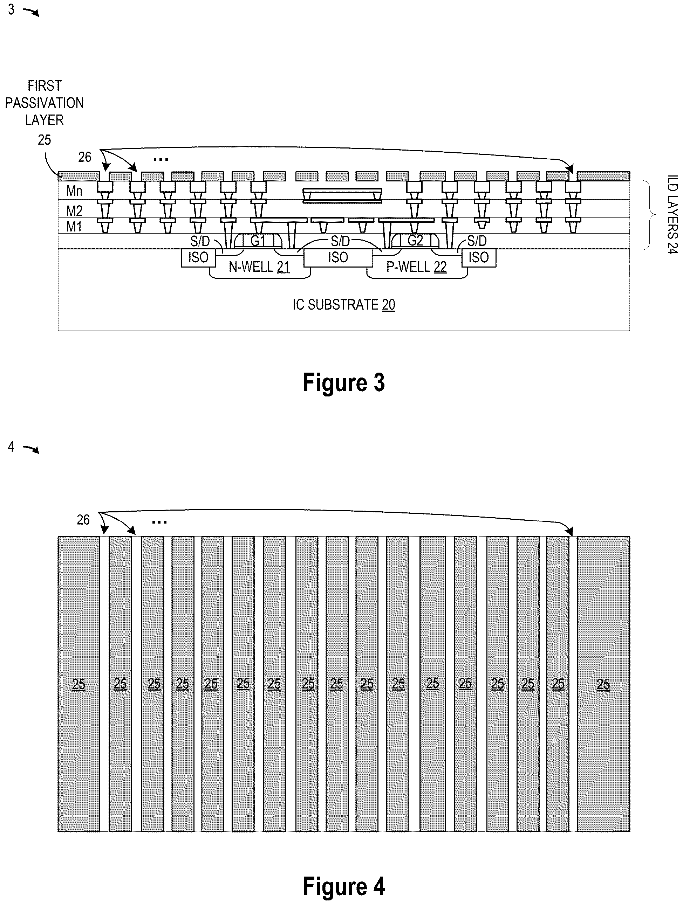

Figure 3 illustrates processing of the semiconductor structure 3 subsequent to Figure 2 after forming a first patterned passivation layer 25 with patterned openings 26 on a top surface of the semiconductor structure 3 in accordance with selected embodiments of the present disclosure. In addition, Figure 4 shows a top plan view 4 of the semiconductor structure in which the first patterned passivation layer 25 is formed with patterned openings 26. In selected embodiments, the patterned openings 26 can extend substantially over the top surface of the semiconductor structure. In other embodiments, the patterned openings 26 (as well as the last metal conductive layers Mn) need not be the size or shape of the finally formed conductive rails 29, but can be discrete islands and shapes where the desired connection point to a common conductive rail 29 is provided by an opening 26 in the first passivation layer 26. As will be appreciated, the first passivation layer 25 in most technologies will have patterned openings 26 with a 2x2um or 3x3 um sized via, although some technologies use wide first passivation openings under the entirety of the pad regions. In embodiments where the conductive rails 29 are formed with regularly-arranged and in-line (RAIL) interconnects that will not have any pads, the first passivation openings 26 need to provide connections between the top metal layer and the RAIL interconnect on the same net. While any suitable fabrication process may be used, the first patterned passivation layer 25 may be formed by depositing one or more suitable dielectric passivation layers (e.g., polyimide, SiN, SiC, SiCN, SiON, SiOx, SixNy, SiCON, a-C or combinations and variations thereof, some of which may also be flourinated) to a predetermined thickness on the entire surface of the semiconductor structure 2, and then sequentially patterning, etching, and/or developing the dielectric passivation layer to define passivation layer openings which expose the underlying last metal conductive layers in the multi-level interconnect structure formed with the ILD layers 24.

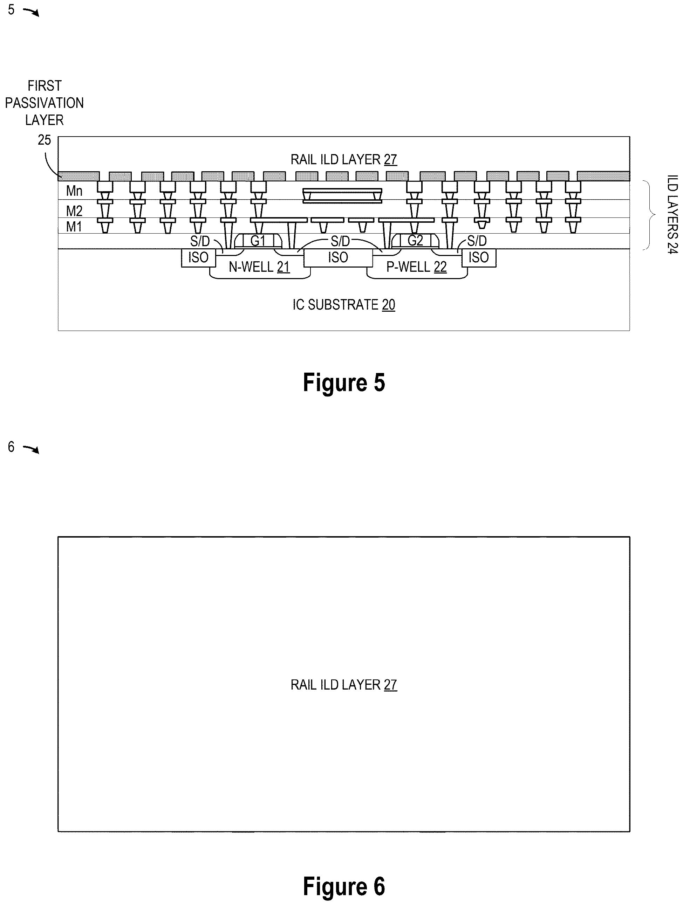

Figure 5 illustrates processing of the semiconductor structure 5 subsequent to Figure 3 after forming a rail ILD layer 27 over the first patterned passivation layer 25 to cover the semiconductor structure in accordance with selected embodiments of the present disclosure. In addition, Figure 6 shows a top plan view 6 of the semiconductor structure which is covered by the rail ILD layer 27. While any suitable fabrication process may be used, the rail ILD layer 27 may be formed by depositing a suitable dielectric layer (e.g., photoimageable polyimide, SiO2, Si3N4, SiON and low-k dielectrics, such as fluorinated SiO2 or fluorinated amorphous Carbon) to a predetermined thickness on the entire surface of the semiconductor structure 2. In selected embodiments, the rail ILD layer 27 may be formed with any dielectric material, including but not limited to tetra-ethyl ortho-silicate (TEOS), fluorinated tetra-ethyl ortho-silicate (FTEOS), or other dielectric material having a dielectric constant, k, that is at least as high as the value of k of silicon dioxide, SiO2, which is 3.9. Dielectric materials having k>3.9 are referred to as "high"-k dielectrics, while dielectric materials having k<3.9 are defined as "low"-k dielectrics. In some embodiments, the dielectric layer may be deposited to a thickness greater than the final desired thickness and then be etched back or planarized to improve thickness uniformity across the semiconductor wafer.

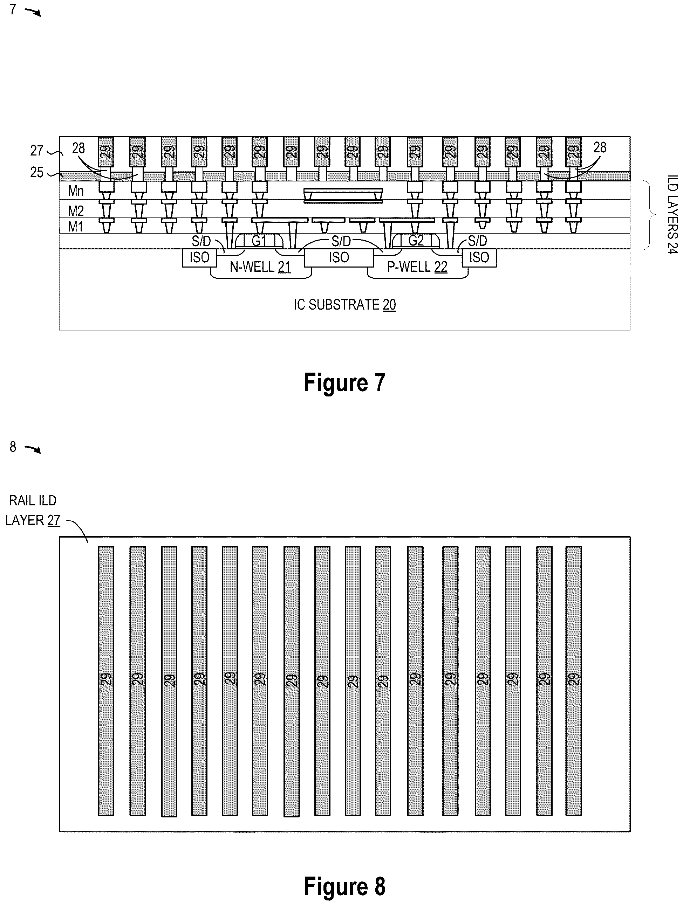

Figure 7 illustrates processing of the semiconductor structure 7 subsequent to Figure 5 after forming an array of parallel conductive rails 29 in the rail ILD layer 27 in accordance with selected embodiments of the present disclosure. In addition, Figure 8 shows a top plan view 8 of the semiconductor structure in which the array of parallel conductive rails 29 extends substantially over the top surface of the rail ILD layer 27. While any suitable fabrication process may be used, the array of parallel conductive rails 29 may be fabricated by forming a patterned photoresist mask (not shown) on the top surface 20 with defined openings to expose the rail ILD layer 27 in alignment with the patterned openings 26 in the first patterned passivation layer 25. Subsequently, the portions of the rail ILD layer 27 exposed by the photoresist mask are selectively etched to form etch openings which align with the patterned openings 26 in the first patterned passivation layer 25. Subsequently, the etch openings are filled with one or more conductive layers to form the conductive metal structures 29 which make direct electrical contact with underlying last metal conductive layers in the multi-level interconnect. As disclosed herein, any suitable deposition process may be used to form the conductive metal structures 29. For example, the conductive metal structures 29 may be formed by first depositing, over the top surface of the semiconductor structure 7, a conductive barrier film or liner layer of any suitable diffusion barrier material which also allows for electro-deposition (e.g., Ti, TiN, Ta, TaN, TiN, TiC, TaC, CuWP, or the like). In selected embodiments, the conductive metal structures 29 may be formed by blanket depositing a barrier film in the etch openings, followed by depositing a thin seed layer (e.g., copper or copper alloy, nickel, etc.) over the barrier film, and then filling the etch openings with metallic material, such as by using electroplating, electroless plating, or depositing a conductive material (e.g., Cu, Co, Ni, Mn, Mg, Zn, Al, etc.). The electroplating process may be controlled to provide a bottom-up electroplating so that the metallic material is formed only on horizontal surfaces to cover the bottom of the etch openings, and to make direct electrical contact with the underlying last metal conductive layers in the multi-level interconnect. The deposited conductive layers are then patterned and etched using any suitable selective etch process(es) to form the conductive metal structures 29. In selected embodiments, the conductive metal structures 29 can be selectively etched, polished, or otherwise planarized, such as by using a chemical mechanical polish (CMP) planarization process. As depicted, the fabrication process used to form the parallel conductive rails 29 to include an optional conductive via structure formed in a first, bottom rail ILD layer and a conductive metal structure formed in a second, upper rail ILD layer. As formed, the conductive metal structures 29 define the array of parallel conductive rails to extend substantially over the top surface of the rail ILD layer 27.

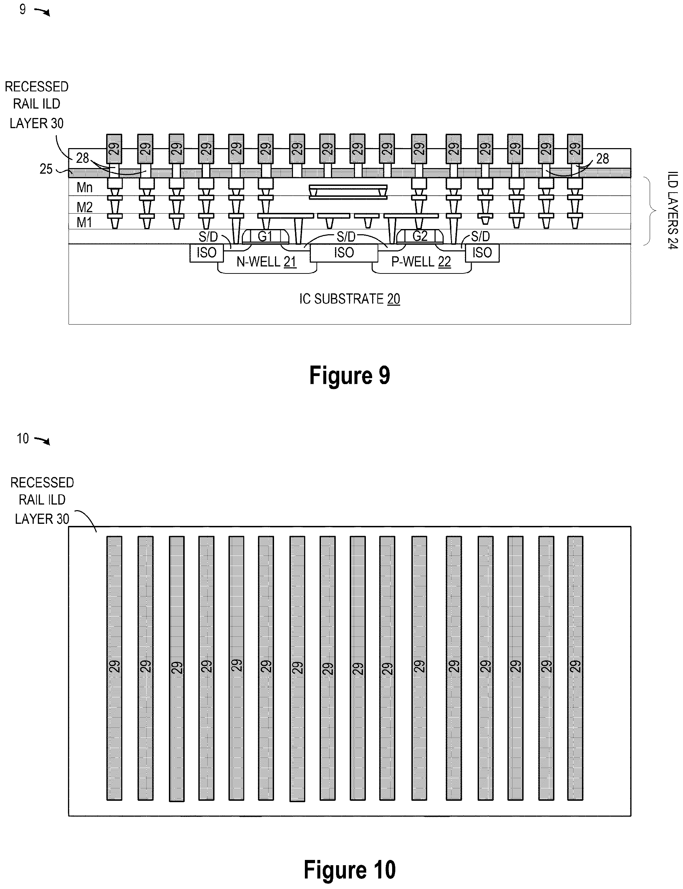

Figure 9 illustrates processing of the semiconductor structure 9 subsequent to Figure 7 after forming a recessed rail ILD layer 30 in accordance with selected embodiments of the present disclosure. In addition, Figure 10 shows a top plan view 10 of the semiconductor structure in which the recessed rail ILD layer 30 and array of parallel conductive rails 29 are formed in the top surface of the semiconductor structure. While any suitable fabrication process may be used, the recessed rail ILD layer 30 may be fabricated by applying one or more controlled etches to recess the top surface of the rail ILD layer 27 by a predetermined distance, such as by applying a timed etch process to selectively recess the upper portion of the rail ILD layer 27 without etching the conductive metal structures 29. No masking is required in such embodiments. As illustrated with the plan view 10 in Figure 10, the array of parallel conductive rails 29 are formed as long, narrow conductive rails which extend in parallel across the length or breadth of the semiconductor structure, allowing for a high conductance path to any underlying buried conductor or buried power rail and provides a uniform stress distribution and reduced resistive loss as compared to conventional metal line conductors which convey power levels "laterally" from die pads at the periphery of the die.

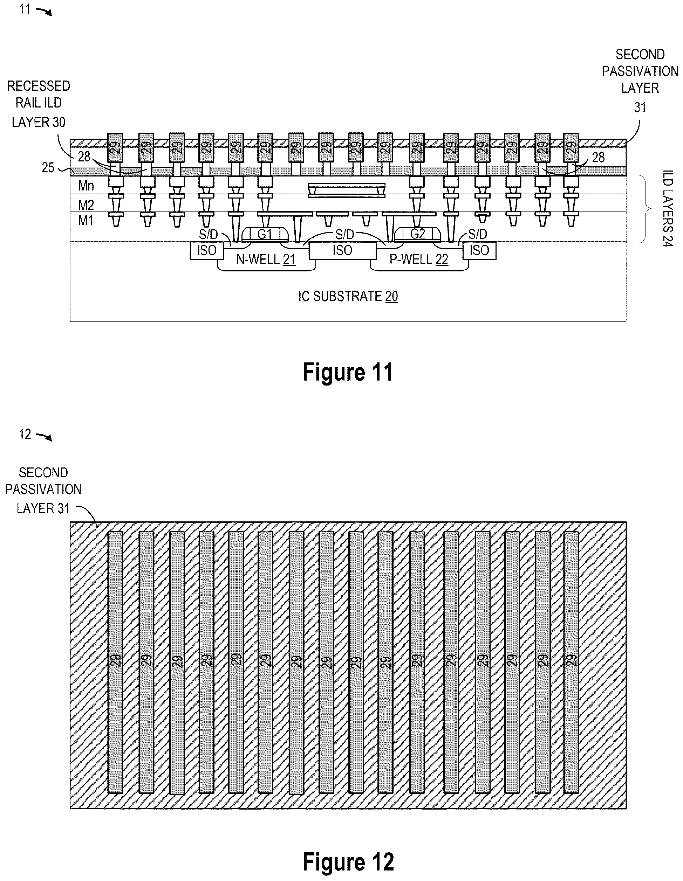

Figure 11 illustrates processing of the semiconductor structure 11 subsequent to Figure 3 after a rail ILD layer is formed as stacked dielectric/passivation/dielectric layers and subsequently etched down to the second passivation layer 31 to help achieve uniform thickness of the recessed rail ILD layer 30 in accordance with selected embodiments of the present disclosure. In addition, Figure 12 shows a top plan view 12 of the semiconductor structure with the exposed second passivation layer 31 and array of parallel conductive rails 29 formed in the top surface of the semiconductor structure. While any suitable fabrication process may be used, the second passivation layer 30 may be formed as part of the rail ILD layer 25 shown in Figure 5 by forming a first lower portion of the rail ILD layer, depositing a suitable dielectric passivation layer (e.g., polyimide, SiO2, or Si3N4) to a predetermined thickness on the first lower portion of the rail ILD layer, and then forming the second upper portion of the rail ILD layer on the second passivation layer 30. With the stacked dielectric/passivation/dielectric layers in place, the fabrication processing steps depicted in Figures 7-8 may be performed, followed by applying one or more controlled etches to etch or recess the second upper portion of the rail ILD layer down to the second passivation layer 31. As illustrated with the plan view 12 in Figure 12, the array of parallel conductive rails 29 are formed as long, narrow conductive rails which extend in parallel across the length or breadth of the semiconductor structure, allowing for a high conductance path to any underlying buried conductor or buried power rail and provides a uniform stress distribution and reduced resistive loss.

In selected embodiments when there are no seal ring or crack-stop structures formed at the periphery of the semiconductor chip, the sequence described with reference to Figures 2-12 can be modified to provide selective top-side, chip-edge and substrate connections. In such embodiments, a wafer containing the semiconductor structure 3 (shown in Figure 3) may be subjected to a plasma dicing operation to etch partially into the IC substrate 20, thereby exposing one or more of the die-side metal routing connections. With the plasma dice lane formed in the wafer, the formation of the rail ILD layer 27 (shown in Figure 5) with a conformal photoimageable polyimide will also cover the sidewalls of the plasma dice lane. When subsequently forming the etch openings in the rail ILD layer 27, the conformal photoimageable polyimide on the sidewalls of the plasma dice lane may be selectively exposed with a laser light source and then developed to expose the one or more of the die-side metal routing connections. Subsequently, a conformal metal layer (e.g., Aluminum) is deposited (such as shown in Figure 7) to fill the etch openings and contact the one or more of the die-side metal routing connections, and if needed, a CMP process may be applied to planarize the top-side conformal metal layer, thereby forming the array of parallel rail conductors 29.

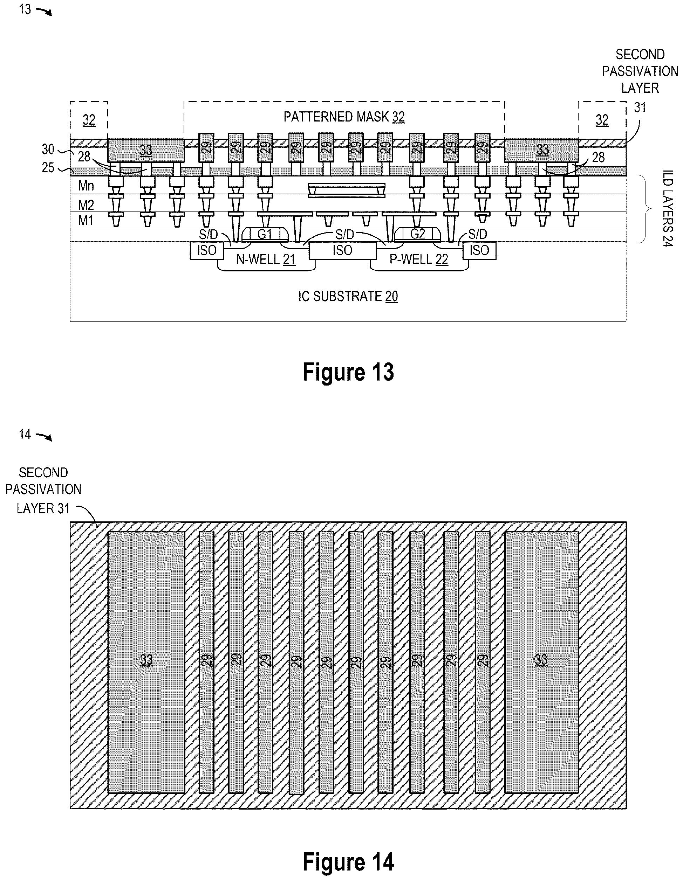

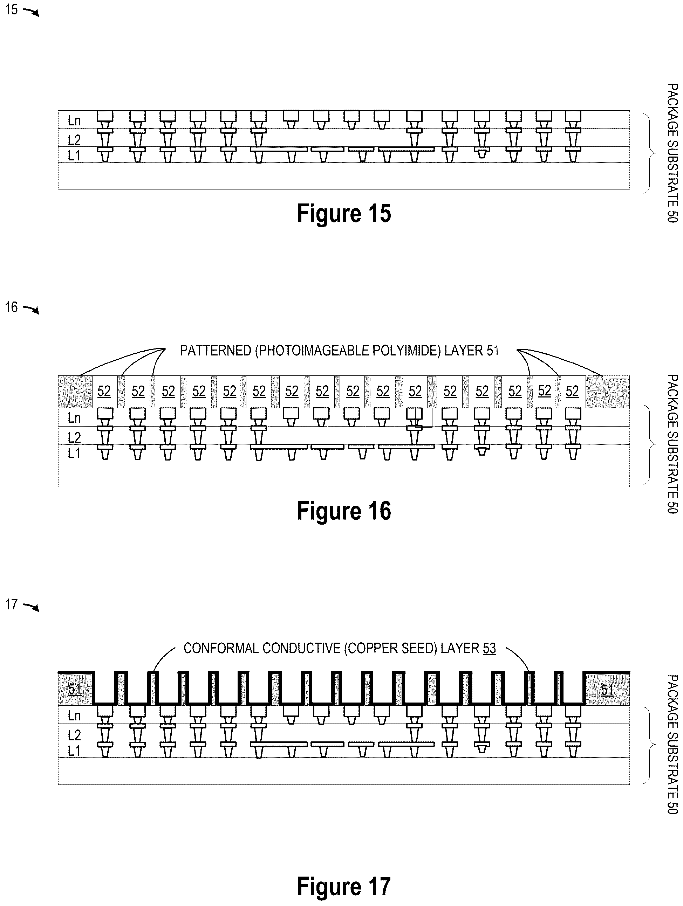

Figure 13 illustrates processing of the semiconductor structure 13 subsequent to Figure 11 after recessed seal ring/crack-stop structures 33 are formed with the array of parallel rail conductors 29 in accordance with selected embodiments of the present disclosure. In addition, Figure 14 shows a top plan view 14 of the semiconductor structure with the array of parallel rail conductors 29 and recessed seal ring/crack-stop structures 33 formed in the top surface of the semiconductor structure 14. Though Figure 15 shows recessed seal ring/crack-stop structures 33 on the opposed left and right peripheral sides of the semiconductor structure, it will be appreciated that recessed seal ring/crack-stop structures 33 may also be formed on the peripheral top and bottom sides of the semiconductor structure to surround the periphery of the chip. While any suitable fabrication process may be used, the recessed seal ring/crack-stop structures 33 may be fabricated by forming a patterned photoresist mask 32 on the top surface 20 with defined openings to expose the peripheral portions of the array of parallel rail conductors 29 where the peripheral seal ring/crack-stop structures 33 will be formed, selectively etching or removing the exposed portions of the peripheral portions of the array of parallel rail conductors 29 to form etch openings where the peripheral seal ring/crack-stop structures 33 will be formed, and then filling the etch openings with one or more conductive layers to form the recessed peripheral seal ring/crack-stop structures 33. As disclosed herein, the etch openings may be filled by depositing, over the top surface of the semiconductor structure 14, a conductive barrier film/liner layer, seed layer(s) and electro-deposition layer(s) to cover the bottom of the etch openings, and the deposited conductive layers may then be patterned and selective etched, recessed, and/or planarized using any suitable selective etch process(es) to form the recessed seal ring/crack-stop structures 33. As illustrated with the plan view 14 in Figure 14, the array of parallel conductive rails 29 are formed as long, narrow conductive rails which extend in parallel across the length or breadth of the semiconductor structure, allowing for a high conductance path to any underlying buried conductor or buried power rail and provides a uniform stress distribution and reduced resistive loss.

As will be appreciated, the recessed seal ring/crack-stop structures 33 may be fabricated with other processing sequences. For example, patterned aluminum (ALUCAP) layers may be formed over the first patterned passivation layer 25 (shown in Figure 5) to make direct electrical contact with underlying last metal conductive layers in the multi-level interconnect. Subsequently, a patterned, timed aluminum recess etch process may be performed to recess the patterned ALUCAP layers that are connected to the underlying seal ring/crack-stop structures in the multi-level interconnect (along with recessing any sensitive RF device aluminum layers (e.g., inductors, transmission lines, baluns, etc.). The result is that only the mounting rails 39 protrude by the amount of the recess etch. Following the recess etch, a conformal passivation layer is formed, but instead of patterning and etching the conformal passivation layer, a CMP step is applied to remove the passivation layer from the top of the protruding mounting rails. For bonding, the tops of the protruding mounting rails are coated with an Under Bump Metallization (UBM) and solder. As an alternative to the timed etch recessing of the ALUCAP to prevent bonding in certain regions, the UBM and solder can be omitted or etched from the top of ALUCAP in areas where bonding in not wanted.

For an improved understanding of selected embodiments of the present disclosure, reference is now made to Figures 15-23 which illustrate a sequence of cross-sectional and plan views at different stages of manufacture of a package substrate structure having rail conductor slots formed to receive rail conductors from a mounted semiconductor chip. In particular, Figure 15 illustrates a cross-sectional view 15 a portion of a package substrate structure 50 having one or more substrate layers L1-Ln formed with sandwiched layers of insulating material (e.g., glass, silicon, plastic and/or fiberglass) that contains a redistribution line (RDL) stack of conductive lines and/or via structures for routing signals and power through the substrate structure 50. While any suitable fabrication process may be used, the package substrate structure 50 may be fabricated by sequentially forming a sequence of insulating layers in which conductive RDL lines and/or via structures are formed in each layer using any suitable process, such as depositing metal and performing a chemical etch to make the layers.

Referring now to Figure 16, there is depicted a processing stage of the semiconductor structure 16 subsequent to Figure 15 after forming a patterned layer 51 with etched openings 52 over the package substrate structure 50. While any suitable fabrication process may be used, the patterned layer 51 may be fabricated by depositing a dielectric layer on the patterned layer 51 to a predetermined thickness. In an example embodiment, the patterned layer 51 may be formed with any suitable polymer or photoimageable polyimide (such as SiN, SiC, SiCN, SiON, SiOx, SixNy, SiCON, or combinations and variations thereof) that is deposited to a predetermined thickness to cover the package substrate 50. Example deposition techniques for forming the photoimageable polyimide layer 51 include, but are not limited to, using spin-on deposition, chemical vapor deposition (CVD), plasma-enhanced chemical vapor deposition (PECVD), squeegee, doctor-blade, or any combination(s) of the above. If desired, a chemical mechanical polish (CMP) step or other suitable planarization step may be used to form the photoimageable polyimide layer 51. On the photoimageable polyimide layer 51, a patterned photoresist mask (not shown) is formed with defined mask openings to expose the photoimageable polyimide layer 51 in alignment with the underlying last layer conductive layers in the package substrate structure 50. Subsequently, the patterned photoresist mask is used to selectively etch any portions of the photoimageable polyimide layer 51 that are exposed by the defined mask openings, thereby forming etched openings 52.

Referring now to Figure 17, there is depicted a processing stage of the semiconductor structure 17 subsequent to Figure 16 after the etch openings 52 are partially filled with one or more conformal conductive layers 53 to make direct electrical contact with the last layer conductive layers in the package substrate structure 50 in accordance with selected embodiments of the present disclosure. In selected embodiments, the one or more conformal conductive layers 53 are formed by blanket depositing a copper seed layer or film 53 in the etch openings 52 and over the patterned photoimageable polyimide layer 51, though other conductive materials (e.g., Copper alloy, Nickel, Silver, Gold, Tungsten, Aluminum, or the like) may be used.

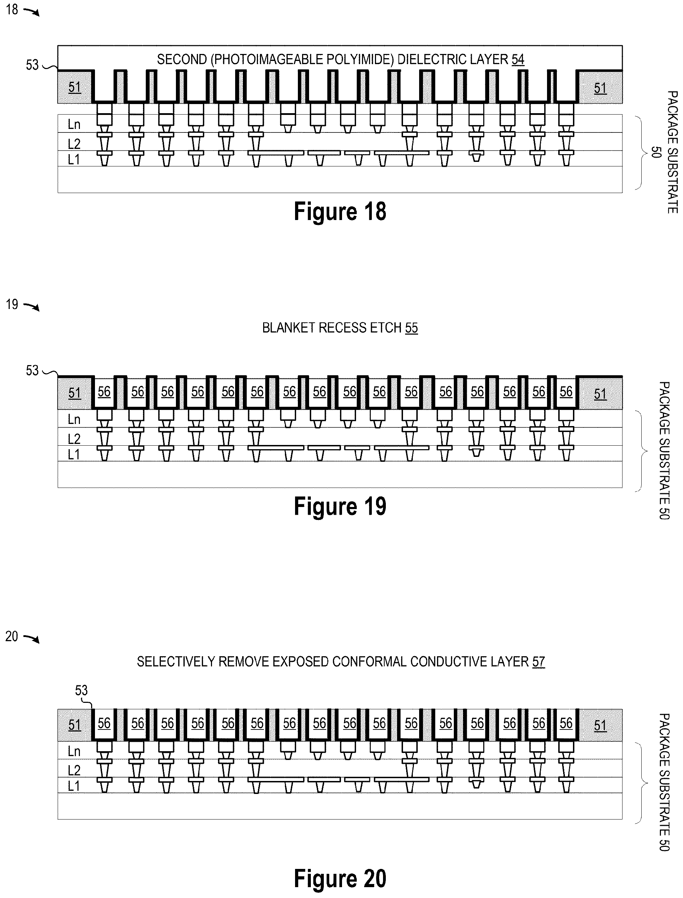

Referring now to Figure 18, there is depicted a processing stage of the semiconductor structure 18 subsequent to Figure 17 after forming a second dielectric layer 54 to cover the one or more conformal conductive layers 53 and fill the etch openings 52 in the patterned layer 51. While any suitable fabrication process may be used, the second dielectric layer 54 may be fabricated by depositing any suitable polymer or photoimageable polyimide (such as SiN, SiC, SiCN, SiON, SiOx, SixNy, SiCON, or combinations and variations thereof) to a predetermined thickness to cover the package substrate 50. If desired, a CMP step or other suitable planarization step may be used to form the second dielectric layer 54.

Referring now to Figure 19, there is depicted a processing stage of the semiconductor structure 19 subsequent to Figure 18 after applying a blanket recess etch 55 to form recessed second dielectric layers 56 in accordance with selected embodiments of the present disclosure. While any suitable fabrication process may be used, the recessed second dielectric layers 56 may be fabricated by applying one or more controlled etches to recess the top surface of the second dielectric layer 54 by a predetermined distance, such as by applying a timed blanket recess etch process 55 to selectively expose the conformal conductive layer(s) 53 on the top surface of the patterned second dielectric layer 51. In other embodiments where the second dielectric layer 54 is formed with a photoimageable polyimide material, the recessed second dielectric layers 56 may be formed by applying a blanket exposure and development process 55 so that a defined uniform layer is removed from the top surface of the photoimageable polyimide layer 54. However applied, the controlled etches expose the one or more conformal conductive layers 53 formed on the top surface of the conformal conductive layer(s) 53 from the top surface of the patterned photoimageable polyimide layer 51 while leaving the conformal conductive layer(s) 53 on the sidewall and bottom surfaces of the etch openings 52.

Referring now to Figure 20, there is depicted a processing stage of the semiconductor structure 20 subsequent to Figure 19 after applying a process 57 to selectively remove the exposed conformal conductive layer(s) 53 from the top surface of the patterned photoimageable polyimide layer 51. While any suitable fabrication process may be used, the exposed conformal conductive layer(s) 53 may be selectively removed by applying one or more wet etches which are selective so that only the exposed conformal conductive layer(s) 53 (and not the patterned photoimageable polyimide layer 51 or the recessed second dielectric layers 56) are removed or etched. In other embodiments, the process 57 includes a CMP step or other suitable planarization to remove the exposed conformal conductive layer(s) 53 from the top surface of the patterned photoimageable polyimide layer 51.

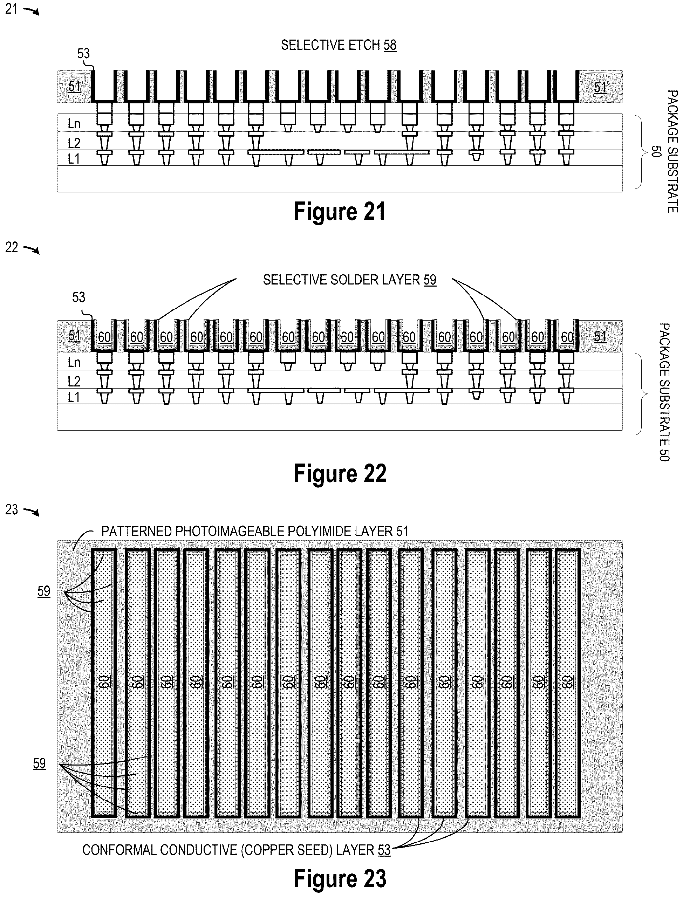

Referring now to Figure 21, there is depicted a processing stage of the semiconductor structure 21 subsequent to Figure 20 after applying a selective etch process 58 to selectively remove the recessed second dielectric layers 56, thereby forming slot openings in the patterned photoimageable polyimide layer 51. While any suitable fabrication process may be used, the recessed second dielectric layers 56 may be selectively removed by applying one or more controlled etches which are selective so that only the exposed recessed second dielectric layers 56 (and not the patterned photoimageable polyimide layer 51) are removed or etched.

Referring now to Figure 22, there is depicted a processing stage of the semiconductor structure 22 subsequent to Figure 21 after selectively forming solder liner layers 59 in the slot openings of the patterned photoimageable polyimide layer 51, thereby forming rail conductor slots 60 which are positioned to receive rail conductors from a semiconductor chip. While any suitable fabrication process may be used, the solder liner layers 59 may be formed by lining the slot openings with metallic material, such as by using electroplating, electroless plating, or depositing a conductive material (e.g., Cu, Co, Ni, Mn, Mg, Zn, Al, etc.). The electroplating process may be controlled to form the metallic material only on the exposed conformal conductive (copper) layers 53. In other embodiments, a blanket solder layer may be applied after forming the conformal conductive (copper) layer(s) 53, and then subsequently patterned and etched and processed as described with reference to Figures 18-21.

Referring now to Figure 23, there is depicted a top plan view of the semiconductor structure 23 shown in Figure 22 with the array of the rail conductor slots 60 defined in the slot openings of the patterned photoimageable polyimide layer 51 with deposited solder liner layers 59 and remaining conformal conductive (copper) layers 53. As illustrated, the array of rail conductor slots 60 are formed as long, narrow slot openings which extend in parallel across the length or breadth of the package substrate structure 50, allowing for a slotted reception of the array of parallel conductive rails 29 (such as shown in Figure 12) from a mounted semiconductor chip. As depicted, the rail conductor slots 60 in the package substrate structure 50 are positioned and disposed as sockets for the array of parallel conductive rails 29 to sit in so that a heating process may be applied so that the selective solder layers 59 make a bond between the socket and rail conductors. However, it will be appreciated that the rail conductor slots 60 may be replaced with protruding copper rails conductor structures which are positioned for alignment and bonding connection with the array of parallel conductive rails 29 protruding from the mounted semiconductor chip.

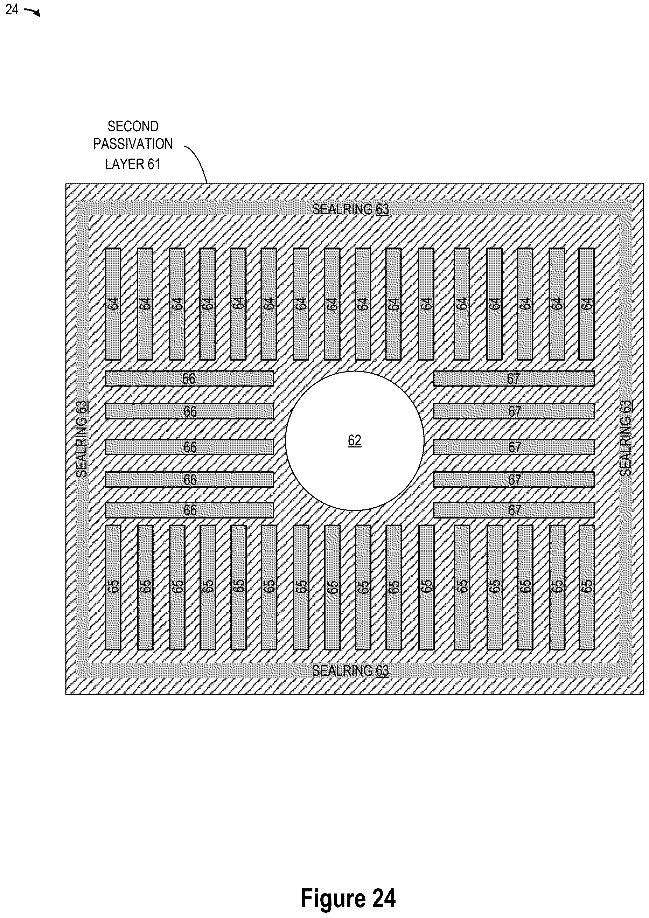

As described hereinabove, the array of parallel conductive rails 29 for a mounted semiconductor chip may have a length dimension which extends across a substantial portion of the top surface of the semiconductor chip. However, the semiconductor chip may have underlying seal ring/crack-stop structures in the multi-level interconnect and/or other sensitive RF device layers, such as inductors, transmission lines, baluns, capacitors, etc., where the array of parallel conductive rails 29 should not be formed. As a result, the layout and arrangement of the array of conductive rail conductors 29 may be defined to include gaps over such underlying structures. In addition or in the alternative, the layout and arrangement of the array of conductive rail conductors 29 may be distributed in different alignments or regions to provide homogenized packaging stress for each separate region. For example, Figure 24 depicts a top plan view of a semiconductor structure 24 in which a stress-sensitive device 62 and peripheral seal ring/crack-stop structure 63 are formed in the underlying multi-level interconnect. In this example, there are four different arrays of parallel conductive rails 64-67 which are arranged to extend through the second passivation layer 61 formed on the top surface of the semiconductor chip. In particular, a first array of parallel conductive rails 64 extends vertically "down" the upper half of the semiconductor structure 24 between the upper seal ring 63 and stress-sensitive device 62 to create a first homogenized packaging stress region. In addition, a second array of parallel conductive rails 65 extends vertically "down" the lower half of the semiconductor structure 24 between the stress-sensitive device 62 and the lower seal ring 63 to create a second homogenized packaging stress region. In addition, a third array of parallel conductive rails 66 extends horizontally "across" the left half of the semiconductor structure 24 between the left seal ring 63 and the stress-sensitive device 62 to create a third homogenized packaging stress region. And a fourth array of parallel conductive rails 67 extends horizontally "across" the right half of the semiconductor structure 24 between the stress-sensitive device 62 and the right seal ring 63 to create a fourth homogenized packaging stress region.

As described hereinabove, the present disclosure provides a mechanism for integrating an array of parallel conductive mounting rails over the multi-level interconnect of a semiconductor chip to significantly reduce the shear stress (e.g., by over 3x reduction) for providing power to integrated circuits as compared to using copper pillars to provide power to integrated circuits. With the disclosed array of parallel conductive mounting rails, uniform across-chip stress distributions are provided where the impact on the circuitry is predictable and minimized. In addition, the array of parallel conductive mounting rails allows for efficient power distribution throughout the die and for low IR loss, and is highly compatible with existing semiconductor fab and substrate manufacturing where TSVs and backside power is being pursued. In addition, providing the array of parallel conductive mounting rails with tight spacing and uniform metal lines acts as an efficient shield to electro-magnetic radiation, and also allows for planar known-good-die probe and simultaneous lead soldering.

By now, it should be appreciated that there has been provided a semiconductor wafer with a plurality of integrated circuit (IC) devices and interconnect structures formed on the semiconductor wafer and associated method of forming power-distribution rail bonding structures, where each IC device and interconnect structure will be singulated into a separate chip. In the disclosed methodology, a semiconductor wafer is provided that contains a plurality of IC devices. The disclosed methodology also includes forming, over each of the plurality of IC devices, an interconnect structure which includes a plurality of conductive interconnect structures extending from each IC device to one more last metal conductive layers in the interconnect structure. In selected embodiments, the interconnect structure is fabricated by forming a copper pillar interconnect structure extending from each IC device to a top of the interconnect structure. The disclosed methodology also includes forming, over each interconnect structure for each IC device, one or more patterned insulator layers having a defined array of patterned openings which extend substantially over the top surface of the interconnect structure to expose the one more last metal conductive layers in the interconnect structure. In selected embodiments, the one or more patterned insulator layers are fabricated by forming a first patterned passivation layer on the interconnect structure having a defined array of patterned openings to expose the one more last metal conductive layers in the interconnect structure. In other selected embodiments, the one or more patterned insulator layers are fabricated by forming a first patterned rail inter-level dielectric (ILD) layer on the first patterned passivation layer having a first defined array of patterned rail openings to expose the one more last metal conductive layers in the interconnect structure. In other selected embodiments, the fabrication of the one or more patterned insulator layers also includes forming a second patterned passivation layer on the first patterned rail ILD layer having a second defined array of patterned openings to expose the one more last metal conductive layers in the interconnect structure; and forming a second patterned rail ILD layer on the second patterned passivation layer having a third defined array of patterned rail openings to expose the one more last metal conductive layers in the interconnect structure. In addition, the disclosed methodology includes forming, over each IC device, an array of conductive power-distribution rail bonding structures in the defined array of patterned openings to extend substantially over the top surface of the interconnect structure, where the array of conductive power-distribution rail bonding structures comprises a plurality of parallel conductive rails which are aligned in parallel and distributed to electrically provide power to the interconnect structure for providing power to the IC device. In selected embodiments, each array of conductive power-distribution rail bonding structures is fabricated by forming an array of regularly-arranged and in-line (RAIL) interconnects on the interconnect structure. In selected embodiments, the array of conductive power-distribution rail bonding structures is fabricated by sequentially depositing one or more conductive layers to fill the defined array of patterned openings, to make ohmic contact with the plurality of conductive interconnect structures to the IC device, and to cover the top surface of the semiconductor wafer; and selectively etching the one or more conductive layers on the top surface of the semiconductor wafer to form the plurality of parallel conductive rails. In selected embodiments, the array of conductive power-distribution rail bonding structures may be fabricated by forming first and second arrays of conductive power-distribution rail bonding structures over first and second regions of the IC device, where the first and second arrays of conductive power-distribution rail bonding structures have different pitch and/or orientation from one another. In selected embodiments, the disclosed methodology may also include partially recessing the one or more patterned insulator layers after forming the array of conductive power-distribution rail bonding structures so that the plurality of parallel conductive rails protrudes above the one or more patterned insulator layers. In selected embodiments, each interconnect structure formed over an IC device includes one or more seal ring structures peripherally embedded in said interconnect structure, in which case each array of conductive power-distribution rail bonding structures formed over the IC device does not extend to cover the one or more seal ring structures. In selected embodiments, the disclosed methodology also includes singulating the semiconductor wafer into a plurality of semiconductor chips, each including an IC device of the plurality of I devices and its respective interconnect structure and its respective array of conductive power-distribution rail bonding structures formed over each IC device of the semiconductor chip. In such embodiments, the disclosed methodology may also include fabricating a package substrate structure with a first mounting surface in which is formed a plurality of conductive mounting slots positioned for mounting engagement with the array of conductive power-distribution rail bonding structures on a first semiconductor chip of the plurality of semiconductor chips. In addition, the disclosed methodology may also include mounting the first semiconductor chip to the package substrate structure using chip-to-chip bonding. In addition or in the alternative, the disclosed methodology may also include selectively applying a layer of solder to one or more of the array of conductive power-distribution rail bonding structures of the first semiconductor chip, to one or more of the plurality of conductive mounting slots positioned for mounting engagement, or to both. In such embodiments, the selective application of solder may omit applying the layer of solder in predetermined locations as needed to prevent connections between the first semiconductor chip and the packet substrate structure.

In another form, there is provided a package assembly and associated method of fabrication. In the disclosed methodology, a package substrate is assembled or provided which has a first surface and an opposed second surface. The disclosed methodology also includes forming a patterned insulator structure on the first surface of the package substrate structure, where the patterned insulator structure has a first upper surface in which is formed an array of patterned openings which extend substantially over the first surface of the package substrate structure to expose one more metal conductive layers formed in the first surface of the package substrate structure. In selected embodiments, the patterned insulator structure may be fabricated by depositing a first photoimageable polyimide layer on the first surface of the package substrate structure; and selectively patterning and etching the photoimageable polyimide layer to form the array of patterned openings. In addition, the disclosed methodology includes forming a conformal conductive layer over the patterned insulator structure to cover the first upper surface and sidewall and bottom surfaces of the array of patterned openings. In selected embodiments, the conformal conductive layer may be fabricated by blanket depositing a conformal copper layer over the patterned insulator structure. The disclosed methodology also includes forming a planarized insulator layer to fill the array of patterned openings and protect the conformal conductive layer formed on the sidewall and bottom surfaces of the array of patterned openings while exposing any conformal conductive layer formed on the first upper surface of the patterned insulator structure. In selected embodiments, the planarized insulator layer may be fabricated by depositing a second photoimageable polyimide layer on the patterned insulator structure to cover the conformal copper layer and fill the array of patterned openings; and selectively recessing the second photoimageable polyimide layer until planarized with the first upper surface of the patterned insulator structure. In addition, the disclosed methodology includes selectively removing any exposed conformal conductive layer formed on the first upper surface of the patterned insulator structure. The disclosed methodology also includes selectively removing any planarized insulator layer formed in the array of patterned openings, thereby forming an array of conductive power-distribution mounting slots in the first surface of the package substrate structure which have a width and length dimension for mounting engagement with an array of conductive power-distribution rail bonding structures formed on a semiconductor chip that is to be mounted on the package substrate structure.

In yet another form, there is provided an integrated circuit package assembly and associated method of manufacture. The disclosed package assembly includes a package substrate having a first array of regularly-arranged and in-line conductive mounting structures or slots. The disclosed package assembly also includes at least a first semiconductor chip device mounted to the package substrate, where the first semiconductor chip device includes an integrated circuit substrate, and multi-level interconnect structure formed on the integrated circuit substrate, and a second array of regularly-arranged and in-line conductive mounting structures or slots formed on the multi-level interconnect structure. In the disclosed package assembly, the second array of regularly-arranged and in-line conductive mounting structures or slots has a length extending across a substantial portion of the first semiconductor chip device. In addition, the first and second arrays of regularly-arranged and in-line conductive mounting structures or slots are positioned and arranged for mounting engagement of the first semiconductor chip device with the package substrate.

Although the described exemplary embodiments disclosed herein are directed to various semiconductor and IC device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for forming power-distribution rail bonding structures, comprising:
providing a semiconductor wafer containing a plurality of integrated circuit (IC) devices; and
forming, over each of the plurality of IC devices, an interconnect structure which comprises a plurality of conductive interconnect structures extending from each IC device to one more last metal conductive layers in the interconnect structure;
forming, over the interconnect structure for each IC device, one or more patterned insulator layers having a defined array of patterned openings which extend substantially over the top surface of the interconnect structure to expose the one more last metal conductive layers in the interconnect structure; and
forming, over each IC device, an array of conductive power-distribution rail bonding structures in the defined array of patterned openings to extend substantially over the top surface of the interconnect structure, where the array of conductive power-distribution rail bonding structures comprises a plurality of parallel conductive rails which are aligned in parallel and distributed to electrically provide power to the interconnect structure for providing power to the IC device.

2. The method of claim 1, where forming one or more patterned insulator layers comprises forming a first patterned passivation layer on the interconnect structure having a defined array of patterned openings to expose the one more last metal conductive layers in the interconnect structure.

3. The method of claim 1 or claim 2, where forming the interconnect structure comprises forming a copper pillar interconnect structure extending from each IC device to a top of the interconnect structure.

4. The method of claim 2, where forming one or more patterned insulator layers comprises forming a first patterned rail inter-level dielectric (ILD) layer on the first patterned passivation layer having a first defined array of patterned rail openings to expose the one more last metal conductive layers in the interconnect structure.

5. The method of claim 4, where forming one or more patterned insulator layers further comprises:
forming a second patterned passivation layer on the first patterned rail ILD layer having a second defined array of patterned openings to expose the one more last metal conductive layers in the interconnect structure; and
forming a second patterned rail ILD layer on the second patterned passivation layer having a third defined array of patterned rail openings to expose the one more last metal conductive layers in the interconnect structure.

6. The method according to any preceding claim, further comprising partially recessing the one or more patterned insulator layers after forming the array of conductive power-distribution rail bonding structures so that the plurality of parallel conductive rails protrudes above the one or more patterned insulator layers.

7. The method according to any preceding claim, where forming the array of conductive power-distribution rail bonding structures comprises:
sequentially depositing one or more conductive layers to fill the defined array of patterned openings, to make ohmic contact with the plurality of conductive interconnect structures to the IC device, and to cover the top surface of the semiconductor wafer; and
selectively etching the one or more conductive layers on the top surface of the semiconductor wafer to form the plurality of parallel conductive rails.

8. The method according to any preceding claim, where forming each array of conductive power-distribution rail bonding structures comprises forming an array of regularly-arranged and in-line (RAIL) interconnects on the interconnect structure.

9. The method according to any preceding claim, where each interconnect structure formed over an IC device comprises one or more seal ring structures peripherally embedded in said interconnect structure, and where each an array of conductive power-distribution rail bonding structures formed over the IC device does not extend to cover the one or more seal ring structures.

10. The method according to any preceding claim, further comprising singulating the semiconductor wafer into a plurality of semiconductor chips, each including an IC device of the plurality of IC devices and its respective interconnect structure and its respective array of conductive power-distribution rail bonding structures formed over each IC device of the semiconductor chip.

11. The method of claim 10, further comprising fabricating a package substrate structure with a first mounting surface in which is formed a plurality of conductive mounting slots positioned for mounting engagement with the array of conductive power-distribution rail bonding structures on a first semiconductor chip of the plurality of semiconductor chips.

12. The method of claim 11, further comprising mounting the first semiconductor chip to the package substrate structure using chip-to-chip bonding.

13. The method of claim 11, further comprising selectively applying a layer of solder to one or more of the array of conductive power-distribution rail bonding structures of the first semiconductor chip, to one or more of the plurality of conductive mounting slots positioned for mounting engagement, or to both

14. The method of claim 13, where selectively applying the layer of solder comprises omitting application of the layer of solder in predetermined locations as needed to prevent connections between the first semiconductor chip and the packet substrate structure.

15. An integrated circuit package assembly, comprising:
a package substrate comprising a first array of regularly-arranged and in-line conductive mounting structures or slots; and
at least a first semiconductor chip device mounted to the package substrate, the first semiconductor chip device comprising an integrated circuit substrate, and multi-level interconnect structure formed on the integrated circuit substrate, and a second array of regularly-arranged and in-line conductive mounting structures or slots formed on the multi-level interconnect structure,
where the second array of regularly-arranged and in-line conductive mounting structures or slots has a length extending across a substantial portion of the first semiconductor chip device, and
where the first and second arrays of regularly-arranged and in-line conductive mounting structures or slots are positioned and arranged for mounting engagement of the first semiconductor chip device with the package substrate.
